# EUROPÄISCHE PATENTANMELDUNG

(11) **EP 1 122 886 A1**
(43) Veröffentlichungstag der Anmeldung: **08.08.2001**
(21) Anmeldenummer: 01102081.5
(22) Anmeldetag: 31.01.2001
(51) Int. Cl.: H03K 17/96

(54) **Schaltungsanordnung für ein kapazitives Sensorelement**

(30) Priorität: 05.02.2000 DE 10005173
(71) Anmelder: E.G.O. Elektro -Gerätebau GmbH, 75038 Oberderdingen (DE)
(72) Erfinder: Gremm, Oliver, 75057 Kürnbach (DE)
(74) Vertreter: Patentanwälte Ruff, Beier und Partner

(57) **Zusammenfassung**

Durch die Erfindung wird eine Schaltungsanordnung für ein Sensorelement eines Berührungsschalters geschaffen, bei der ein hochfrequentes Ansteuersignal (13) an dem Sensorelement (15) anliegt. Die Schaltungsanordnung (11) weist folgende Elemente auf:

Eine Signalquelle (12) für das Ansteuersignal (13); einen Transistor (T), an dessen Basis (B) das Ansteuersignal (13) über ein Paßfilter (R1, C1) und einen Spannungsteiler (C1, 15) anliegt; einen Widerstand (R2) gegen Masse (18), der für einen gewissen Basisstrom sorgt; der Transistorkollektor (C), an dem das Ausgangssignal (17) anliegt, liegt über einen Kondensator (C2) an Masse; zwischen Transistorbasis (B) und Masse befindet sich ein kapazitives Sensorelement (15). Ein bevorzugtes Anwendungsgebiet der Erfindung ist ein Berührungsschalter eines Glaskeramik-Kochfeldes eines Elektroherdes

## Beschreibung

### ANWENDUNGSGEBIET UND STAND DER TECHNIK

Die Erfindung betrifft eine Schaltungsanordnung für wenigstens ein Sensorelement, wenigstens eines Berührungsschalters, insbesondere auf kapazitiver Basis arbeitend. Dabei liegt ein Ansteuersignal, das eine bestimmte Arbeitsfrequenz aufweist, an dem Sensorelement an und wird, abhängig von dem Betätigungszustand des Sensorelementes, verändert. Das Sensorelement kann beispielsweise durch Annähern oder Auflegen eines Fingers betätigt werden, wodurch ein Schaltsignal dargestellt werden soll. Dieses Schaltsignal erkennt die Schaltungsanordnung, wertet sie aus und gibt sie an weitere Schaltungseinrichtungen weiter.

Eine Schaltungsanordnung dieser Art ist beispielsweise aus der DE 19 706 167 oder der US 5,270,710 bekannt. Dabei sind die Schaltungsanordnungen jeweils entweder relativ aufwendig oder aber von unzureichender Funktionalität.

### AUFGABE UND LÖSUNG

Der Erfindung liegt die Aufgabe zugrunde, eine Schaltungsanordnung der zuvor genannten Art zu schaffen, die zum einen einfach aufgebaut ist und mit einer relativ geringen Anzahl standardmäßig verwendeter Bauelemente aufgebaut werden kann sowie den Einfluß von Störungen minimiert.

Gelöst wird diese Aufgabe durch eine Schaltungsanordnung mit den Merkmalen des Anspruchs 1. Vorteilhafte Ausgestaltungen der Erfindung sind Gegenstand der Unteransprüche und werden auch im folgenden erläutert.

Erfindungsgemäß weist die Schaltungsanordung eine Signalquelle auf, die das Ansteuersignal liefert, welches in der Regel ein Wechselstromsignal ist. Weiterhin ist ein Transistor enthalten, an dessen Transistorbasis das Ansteuersignal über einen Filter und/oder einen Spannungsteiler anliegt. Als Filter wird bevorzugt ein Paßfilter verwendet. Mittels eines Widerstandes wird ein zumindest minimaler Basisstrom am Transistor erzeugt. Der Transistorkollektor ist über einen Kondensator an Masse geführt. Am Transistorkollektor kann das Ausgangssignal der Schaltungsanordnung abgegriffen werden zur weiteren Verarbeitung. Zwischen Transistorbasis und Masse ist das Sensorelement angeschlossen, wobei es sich bei dem Sensorelement um ein kapazitives Sensorelement handelt. Das Filter kann neben der Filterwirkung vorteilhaft dazu benutzt werden, eine Signalverschiebung zu erzeugen.

Ein besonders bevorzugtes kapazitives Sensorelement ist beispielsweise in der DE-OS 297 21 212 beschrieben deren Inhalt durch ausdrückliche Bezugnahme zum Inhalt dieser Beschreibung genommen wird. Es kann nach Art eines einteiligen Körpers aus leitfähigem Schaumstoff ausgebildet sein. Durch Anlegen eines Fingers eines Benutzers an dieses Sensorelement wird die kapazitive Kopplung des Benutzers gegen Masse erzeugt, und Sensorelement samt Benutzer können als gegen Masse geschaltetes Kondensator gesehen werden. Der Einsatz anderer Sensorelemente ist selbstverständlich möglich.

Das Paßfilter ist vorteilhaft ein Hochpass. Es kann aus einem Widerstand und einem Kondensator aufgebaut sein.

Der Spannungsteiler kann kapazitiver Art sein. Vorteilhaft kann er so ausgeführt sein, daß ein Kondensator des Spannungsteilers Bestandteil des zuvor erwähnten Paßfilters ist. Ebenso können Widerstände Teil des Spannungsteilers sein. Dadurch läßt sich die Anzahl der Bauteile reduzieren.

Weiterhin ist bevorzugt ein Widerstand vorgesehen, über den wenigstens der Kondensator zwischen Transistorkollektor und Masse entladen werden kann. Dieser Entladevorgang liegt in einer Phase, in der das Ansteuersignal Nullpotential oder ein geringeres Potential aufweist. Vorteilhaft können auch der Kondensator des kapazitiven Spannungsteilers und/oder ein Kondensator des Paßfilters entladen werden, insbesondere auch über diesen Widerstand.

Das am Transistorkollektor abgreifbare Ausgangssignal wird zur Weiterverarbeitung beispielsweise an einen Mikrokontroller gegeben. Dieser bestimmt, ob eine Betätigung bzw. eine gewollte Schaltauslösung stattgefunden hat. Insbesondere kann dies durch einen Einbruch der Ansteuerspannung festgestellt werden, wenn bei Betätigung eine weitere Kapazität gegen Masse geschaltet ist. Durch die Verwendung der vorliegenden Erfindung ist es möglich, einen derart großen Signalhub der Schaltung zu erreichen, daß eine Auswertung des Ausgangssignals ohne Verstärker vorgenommen werden kann. Besonders bevorzugt wird als Ansteuersignal ein unipolares Rechtecksignal.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### KURZBESCHREIBUNG DER ZEICHNUNGEN

Ausführungsbeispiele der Erfindung sind in den Zeichnungen dargestellt und werden im folgenden näher erläutert. In den Zeichnungen zeigen:
- Fig. 1: Eine anschauliche Schaltungsanordnung zur Darstellung der Erfindung sowie
- Fig. 2 bis Fig. 7: weitere Ausführungsbeispiele der Erfindung in jeweils abgewandelter Form.

### DETAILLIERTE BESCHREIBUNG DER AUSFUHRUNGSBEISPIELE

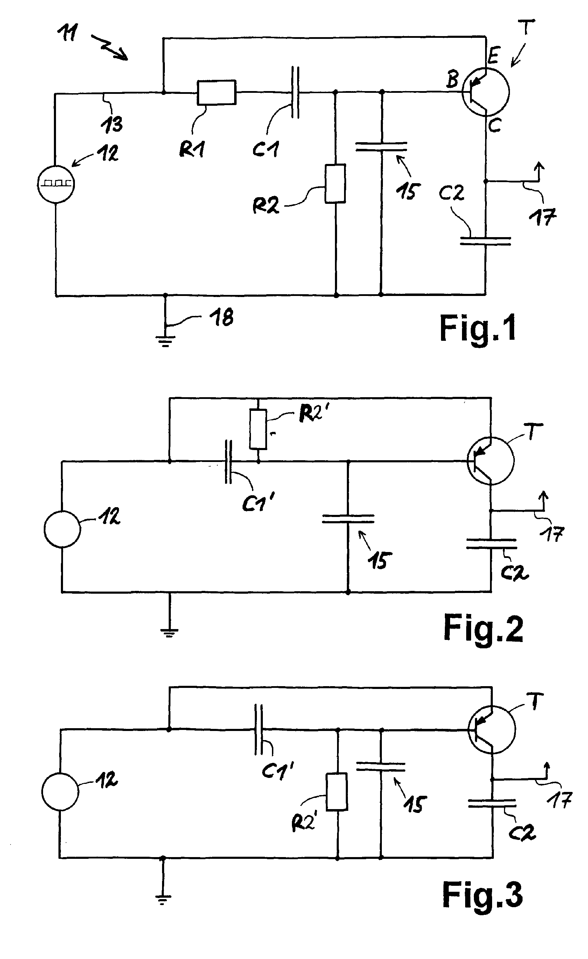

Die Fig. 1 zeigt ein Ausführungsbeispiel einer Schaltungsanordnung 11, an der die prinzipiellen Grundelemente der Erfindung dargestellt sowie die Funktionsweise erklärt werden sollen. Von einer Ansteuersignalquelle 12 wird ein Ansteuersignal 13 erzeugt, im vorliegenden Fall beispielsweise ein unipolares Rechtecksignal. Das Ansteuersignal 13 wird einerseits direkt auf den Emitter E eines Transistors T, hier beispielhaft ein PNP-Transistor vom Typ Q2N2907A, gegeben.

Des weiteren wird das Ansteuersignal 13 über den Widerstand R1 sowie einen Kondensator C1 an die Basis B von T gegeben. Der Widerstand R1 und der Kondensator C1 bilden dabei ein Paßfilter für das an der Basis anliegende Ansteuersignal. Eine beispielhafte Dimensionierung der Werte für R1 und C1 liegt bei 470 kOhm sowie bei 47 pF.

Weiters ist die Basis B des Transistors T über einen Widerstand R2 an den Masseanschluß 18 gelegt. Der Widerstand R2 ermöglicht ein Vorspannen des Transistors, so daß mindestens ein minimaler Basisstrom fließen kann. Als beispielhafter Wert für den Widerstand R2 können 10 MOhm verwendet werden.

Zusätzlich ist zwischen der Basis B und dem Masseanschluß 18 ein Sensorelement 15 (exemplarisch dargestellt durch das Schaltungssymbol eines Kondensators) geschaltet.

In Abweichung von dieser schaltungstechnischen Darstellung ist in der Realität das Sensorelement 15 im wesentlichen von einer Kondensatorplatte gebildet, die in der Regel an einem Dielektrikum oder dergleichen anliegt. Legt ein Benutzer einen Finger an das Dielektrikum gegenüber dieser Kondensatorplatte, so wird von dieser Berührfläche die zweite Kondensatorplatte gebildet, die über den Benutzer mit Masse verbunden ist. Weiters bilden der Kondensator C1 und das Sensorelement 15 einen kapazitiven Spannungsteiler, deren Verhältnis zueinander die Stärke des Ansteuersignals 13 an der Basis B bestimmt.

Der Kollektor C des Transistors T ist über einen Kondensator C2 an den Masseanschluß 18 gelegt. Für C2 kann beispielsweise ein Wert von 22 nF gewählt werden. Weiters geht vom Kollektor C ein Abgriff an einen Mikrokontroller oder dergleichen ab, an dem das Ausgangssignal 17 anliegt. Dieses Ausgangssignal 17 kann von dem nicht dargestellten Mikrokontroller oder einer anderen nachgeordneten Schaltungsanordnung ausgewertet werden.

### FUNKTION DES AUSFÜHRUNGSBEISPIELS GEMÄß FIGUR 1

Im folgenden soll kurz die Funktionsweise der Schaltungsanordung 11 gemäß Figur 1 dargestellt werden:

Das Ansteuersignal 13, das exemplarisch ein unipolares Rechtecksignal mit einer Frequenz von ca. 50 kHz sein kann, wird über das Hochpaßfilter aus R1 und C1 an die Basis B des Transistors T gegeben. Im unbetätigten Zustand des Sensorelements 15 ist dieses in der Schaltung nicht vorhanden bzw. die Verbindung zum Masseanschluß 18 unterbrochen. Im Falle der Betätigung des Sensorelements 15 liegt dagegen die Schaltungsanordnung gemäß Fig. 1 vor, das Sensorelement 15 ist zu einem an Masse gelegten Kondensator geworden.

Das Hochpaßfilter dient vor allem zur Eingangsstöruntekdrückung an der Basis. Der Kondensator C1 und das Sensorelement 15 (als Kondensator) stellen einen kapazitiven Spannungsteiler dar. In Abhängigkeit von ihrem Größenverhältnis zueinander wird das Ansteuersignal an der Basis B bedämpft bzw. heruntergesetzt. Dies führt dazu, daß der Transistor T mehr öffnet und der Kondensator C2 am Kollektor auf einen höheren Spannungswert aufgeladen wird. Diese Veränderung wiederum kann aus dem Ausgangssignal 17, das demzufolge ebenfalls einen höheren Spannungswert aufweist, abgelesen werden. Endet die Betätigung des Sensorelements 15, so fällt der dadurch gebildete Kondensator wieder weg, ebenso die Bedämpfung und der Spannungswert des Ausgangssignals 17 am Kollektor sinkt, weil der Transistor T wieder mehr schließt.

Demzufolge arbeitet der Transistor in dieser Schaltung als ein veränderlicher Widerstand, der über seine Basis gesteuert wird. Dabei dient der Widerstand R2 zur Entladung der Kapazitäten (C1, C2, Sensorelement 15) während der Zeit, in der das Ansteuersignal 13 auf 0 Volt oder niedriger liegt.

Insgesamt ist es durch die erfindungsgemäße Schaltung, beispielsweise gemäß Fig. 1, möglich, einen besonders großen Signalhub der Schaltung zu erreichen. Dieser kann so groß sein, daß es möglich ist, ohne Verstärker das Ausgangssignal 17 auszuwerten. Das Ausgangssignal 17 an dem Kollektor C des Transistors T liegt als Gleichspannung vor. Durch das Hochpaßfilter wird auch das HF-Verhalten der Schaltung weit verbessert.

Ein Anwendungsbeispiel für eine erfindungsgemäße Schaltungsanordnung samt Sensorelement ist ein Berührungsschalter für die Steuerung eines Elektroherdes. Dabei kann das Sensorelement 15 unter einer Glaskeramik-Kochplatte des Elektroherdes angebracht sein und von oben durch Anlegen eines Fingers betätigt werden.

### WEITERE SCHALTUNGSBEISPIELE

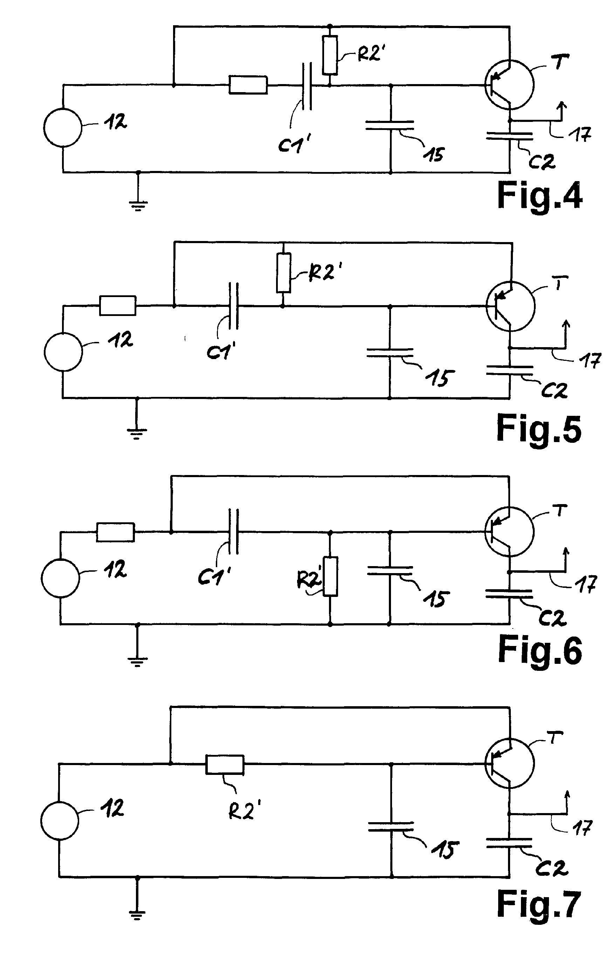

Weitere Ausführungsbeispiele für eine Schaltungsanordnung sind in den Fig. 2 bis 7 dargestellt, die jeweils Abwandlungen der Schaltungsanordnung 11 aus Fig. 1 sind. Die erfindungswesentlichen Merkmale sind jeweils verwirklicht, lediglich die Ausbildung des Eingangs-Filters sowie des Spannungsteilers (kapazitiv oder gemischt kapazitiv-ohmsch) variieren. Insofern wird es als nicht notwendig erachtet, auf diese Schaltungen jeweils im einzelnen einzugehen. Das Funktionsprinzip der Schaltung bleibt jeweils erhalten. Mit R1' und C1' werden jeweils Variationen des Widerstands zum Vorspannen des Transistors und des Kondensators für den kapazitiven Spannungsteiler mit dem Sensorelement 15 dargestellt. Lediglich die Schaltungsanordnung gemäß Fig. 7 bildet insofern eine Ausnahme, als daß hier der Spannungsteiler gemischt ohmsch-kapazitiv ist, und zwar ohne einen Kondensator C1'. Den kapazitiven Teil bildet hier das Sensorelement 15.

Selbstverständlich kann die Schaltung auf weitere Weisen als die Dargestellten realisiert werden.

## Patentansprüche

1. Schaltungsanordnung für wenigstens ein Sensorelement (15) wenigstens eines Berührungsschalters, bei der ein Ansteuersignal (13) mit einer Arbeitsfrequenz an dem Sensorelement (15) anliegt und abhängig von dem Betätigungszustand des Sensorelements veränderbar ist, gekennzeichnet durch:
- eine Signalquelle (12) für das Ansteuersignal (13), wobei das Ansteuersignal ein Wechselstromsignal ist
- einen Transistor (T), wobei das Ansteuersignal (13) über ein Filter (R1, C1) und einen Spannungsteiler (C1, 15) an der Transistorbasis (B) anliegt
- einen Widerstand (R2), der für einen minimalen Basisstrom am Transistor (T) sorgt
- der Transistorkollektor (C) liegt über einen Kondensator (C2) an Masse, wobei am Transistorkollektor das Ausgangssignal (17) abgegriffen werden kann
- zwischen Transistorbasis (B) und Masse ist das Sensorelement (15) angeschlossen
- das Sensorelement ist ein kapazitives Sensorelement (15).

2. Schaltungsanordnung nach Anspruch 1, dadurch gekennzeichnet, daß das Filter (R1, C1) ein Hochpaß aus einem Widerstand (R1) und einem Kondensator (C1) ist.

3. Schaltungsanordnung nach Anspruch 1 oder 2, dadurch gekennzeichnet, daß der Spannungsteiler (C1, 15) kapazitiv ist, wobei vorzugsweise ein Kondensator (C1) des Spannungsteilers (C1, 15) Bestandteil des Paßfilters (R1, C1) nach Anspruch 2 ist.

4. Schaltungsanordnung nach Anspruch 1 oder 2, dadurch gekennzeichnet, daß der Spannungsteiler (R2', 15) gemischt ohmsch-kapazitiv ist, wobei vorzugsweise das Sensorelement (15) kapazitiver Teil ist.

5. Schaltungsanordnung nach einem der vorhergehenden Ansprüche, dadurch gekennzeichnet, daß ein Widerstand (R2) vorgesehen ist, über den mindestens der Kondensator (C2) am Transistorkollektor entlädt wird in einer Phase, in der das Ansteuersignal 0 Volt nicht überschreitet, wobei vorzugsweise auch der Kondensator (15) des kapazitiven Spannungsteilers (C1, 15) und/oder der Kondensator (C1) des Paßfilters (R1, C1) entladen werden.

6. Schaltungsanordnung nach einem der vorhergehenden Ansprüche, dadurch gekennzeichnet, daß das Ausgangssignal (17) an einen Microcontroller weitergegeben wird zur Auswertung bzw. Weiterverarbeitung.

7. Schaltungsanordnung nach einem der vorhergehenden Ansprüche, dadurch gekennzeichnet, daß das Ansteuersignal (13) ein unipolares Rechtecksignal ist.
